(19) Europäisches Patentamt / European Patent Office / Office européen des brevets

(11) **EP 3 401 923 A1**

(12) **EUROPEAN PATENT APPLICATION**

(43) Date of publication:
**14.11.2018 Bulletin 2018/46**

(51) Int Cl.:
**G21B 3/00** (2006.01)          **H05H 1/46** (2006.01)

(21) Application number: **17170750.8**

(22) Date of filing: **12.05.2017**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(71) Applicant: **RIToN Holding Ltd**
**Tortola (VG)**

(72) Inventor: **LIDGREN, Hans**
**MC-98000 Monaco (MC)**

(74) Representative: **AWA Sweden AB**
**P.O. Box 5117**
**200 71 Malmö (SE)**

(54) **A METHOD FOR AMPLIFYING ENERGY AND A POWER AMPLIFIER**

(57)     A power amplifier for amplifying power of electromagnetic radiation is disclosed. The power amplifier comprising: a first gaseous fuel component being deuterium; a second gaseous fuel component, the second component being another gas than deuterium, the second gaseous fuel component being selected such that a nucleus mass reducing isotope shift in deuterium is less energy requiring than a nucleus mass increasing isotope shift in the second fuel component; and a fuel compartment (12) containing a mixture of the first and second gaseous fuel components. Also a method for amplifying power of electromagnetic radiation is disclosed.

Fig. 2

EP 3 401 923 A1

**Description**

Technical field

The present invention relates to a method for amplifying energy. The invention also relates to a power amplifier.

Background

Production of energy is one of the top most priorities of mankind. A lot of effort is put into finding new technologies for energy production. A first step in a new technology of energy production is disclosed in EP 3 086 323 A1.

Summary of the invention

In view of the above, it is an object of the present invention to provide novel means for energy production.

According to a first aspect a method for amplifying power of electromagnetic radiation is provided. The method comprises:

subjecting a fuel mixture to input electromagnetic radiation, the fuel mixture comprising a first and a second fuel component, the first fuel component being gaseous deuterium and the second component being another gas than deuterium, for producing:

a nucleus mass reducing isotope shift in the deuterium,
a nucleus mass increasing isotope shift in the second fuel component, and
output electromagnetic radiation resulting from the nucleus mass increasing isotope shift;

wherein the nucleus mass reducing isotope shift in deuterium is less energy requiring than the nucleus mass increasing isotope shift in the second fuel component.

By subjecting or exposing a fuel mixture to input electromagnetic, EM, radiation is here meant that input EM radiation irradiates at least a portion of the first fuel component. The input EM radiation may comprise photons having at least one frequency, or frequency mode. In a first example, the input EM radiation comprises photons having a plurality of frequency modes. In a second example, the input EM radiation is substantially monochromatic comprising photons with a fixed frequency. Moreover, the input EM radiation may have a preferred level of intensity and/or power. The preferred level of intensity and/or power may be associated with specific frequencies. Optionally, the input EM radiation may be polarized.

The input EM radiation may affect the fuel such that the fuel will enter a plasma phase.

Further, the input EM radiation may transfer energy to the first fuel component. The energy transfer may be provided by means of a wave-particle acceleration process. Upon transferring energy to the first fuel component it will assume a high-energy state wherein the neutrons of the first fuel component will be affected and a nucleus mass reducing isotope shift will occur. At least a portion of the first fuel component may assume the high-energy state. Typically, the nucleus mass reducing isotope shift will occur when the energy transferred by the input EM radiation is higher or equal to a threshold energy. Additionally, however, a quantum mechanical tunnelling effect may allow for the nucleus mass reducing isotope shift below the threshold energy.

The wave-particle acceleration process may be chosen based on physical properties of the first fuel component. By way of example, the physical properties of the first fuel component may relate to a type of material of the first fuel component, a type of lattice structure of the material, physical quantities of the material, such as its atomic mass, number of atoms, atomic separation distance, speed of sound, characteristic plasma velocity, local temperature, average temperature, etc., length dimensions of the lattice structure of the material, length dimensions of a grain structure of the material, and geometry of the lattice structure of the material. The physical properties may also be a plasma resonance frequency of the first fuel component.

The energy received by the wave-particle acceleration process, may be transferred to the first fuel component at a preferred intensity. The plasma resonance frequency has an associated frequency w and an associated resonant wave length $\lambda$.

According to the inventive method, a nucleus mass reducing isotope shift is produced in the first fuel component. Neutrons released from the first fuel component at the nucleus mass reducing isotope shift of the first fuel component will induce a nucleus mass increasing isotope shift in the second fuel component. Excess energy resulting from the mass increasing isotope shift in the second fuel component may be outputted as electromagnetic radiation.

The first fuel component comprises deuterium, D. Before being subjected to the input EM radiation, the first fuel component may be in gas phase. Hence, initially, before being subjected for the input EM radiation, the first fuel component may be deuterium gas, $D_2$. One advantage of using deuterium is that it is cheap. Another advantage is that the use of deuterium leads to a high net gain in amplification of power of electromagnetic radiation.

The second fuel component may comprise a gas. The second fuel component may comprise nitrogen, $N_2$, gas. The second fuel component may comprise $^{14}N_2$. Nitrogen gas is preferred since $^{14}N$ may capture a neutron by the nucleus mass increasing isotope shift forming $^{15}N$. Both $^{14}N$ and $^{15}N$ are stable isotopes of nitrogen. Further, the difference in mass of $^{15}N$ and $^{14}N$ is higher than the rest mass for a neutron. The mass increasing isotope shift in the nitrogen gas from $^{14}N$ and $^{15}N$ will result in energy being outputted as electromagnetic radiation.

By the second fuel component undergoing the nucleus mass increasing isotope shift excess energy will be generated. More particularly, the process of the nucleus mass increasing isotope shift in the second fuel component may release more energy than the energy required for the nucleus mass reducing isotope shift in the first fuel component.

By means of the inventive concept, there are normally no element transmutations. Instead, there are isotope shifts of the first fuel component and of the second fuel component. By isotopes is meant a set of nuclides having the same atomic number Z but having different neutron numbers N=A-Z, where A is the mass number. In the process of isotope shift, the mass number A of the isotope is shifted by at least one integer step. The mass reducing isotope shift may be an isotope shift from an isotope $^AP$ with mass number A to an isotope $^{A-1}P$ with mass number A-1. The mass increasing isotope shift may be an isotope shift from an isotope $^AP$ with mass number A to an isotope $^{A+1}P$ with mass number A+1.

The mass reducing isotope shift in the first fuel element may originate from the reaction channel $D + W_s \rightarrow n + {}^1H$, where D is deuterium, $^2H$, and where $^1H$ is protium, i.e. hydrogen with no neutron in the nucleus. Further, $W_s$ is the threshold energy for the mass reducing isotope shift to occur. The threshold energy for inducing a mass reducing isotope shift in D is 2.25 MeV. It is noted that $^1H$ as well as $^2H$ are stable isotopes per se, but that the reaction above may be induced by irradiation above the threshold energy.

By output electromagnetic, EM, radiation is here meant energy which is released in the process of the nucleus mass increasing isotope shift in the second fuel component. The energy will be released in the form of electromagnetic waves/photons. For example, in case the second fuel component comprises $^{14}N$ the mass increasing isotope shift to $^{15}N$ will make available 10.8 MeV of energy. Hence, almost 5 times more energy than is need for the mass reducing isotope shift from deuterium, D, to protium, H.

An initial ratio between the first and second fuel components may be within 40/60 mol percentage to 60/40 mol percentage, preferably 50/50 mol percentage.

The input electromagnetic radiation may have a frequency of 300 GHz to 300 MHz or below. Hence, the input electromagnetic radiation may be in the microwave range of electromagnetic radiation. The input electromagnetic radiation may have a frequency of 2 to 3 GHz, preferably 2.5 GHz. Hence, microwave radiator of the same type as used in today's microwave ovens may be used. This makes it cheap and efficient to implement the method.

The output electromagnetic radiation may have a frequency of 500 GHz to 1.5 THz.

Hence, in accordance with the inventive concept expressed both in general and in more detailed terms in the above, there is provided a method for amplifying power of electromagnetic radiation.

According to a second aspect a power amplifier for amplifying power of electromagnetic radiation is provided. The power amplifier comprises:

a first gaseous fuel component being deuterium;
a second gaseous fuel component, the second component being another gas than deuterium, the second gaseous fuel component being selected such that a nucleus mass reducing isotope shift in deuterium is less energy requiring than a nucleus mass increasing isotope shift in the second fuel component; and
a fuel compartment containing a mixture of the first and second gaseous fuel components.

The above mentioned features of the method, when applicable, apply to this second aspect as well. In order to avoid undue repetition, reference is made to the above.

The fuel compartment may be gas tight for the first and second gaseous fuel components.

The fuel compartment may be a closed compartment. Thereby it is possible to provide the power amplifier as a separate member. It is e.g. possible to dispense with any connections to gas supplies. The power amplifier is thereby easy to implement and use in various applications. The power amplifier is thereby also easy to provide as a replaceable unit or member, which e.g. may be replaced after the first and/or second fuel component has been used up or to a certain degree.

The fuel compartment may comprise a radiation input surface permeable for input electromagnetic radiation having a frequency of 300 MHz to 300 GHz, preferably 2 to 3 GHz, more preferably 2.5 GHz. Thereby the first fuel component may effectively be subjected to electromagnetic radiation having a frequency of 300 MHz to 300 GHz, preferably 2 to 3 GHz, more preferably 2.5 GHz.

The fuel compartment may comprise a radiation output surface permeable for output electromagnetic radiation having a frequency of 500 GHz to 1.5 THz. Thereby the output electromagnetic radiation having a frequency of 500 GHz to 1.5 THz may efficiently be outputted from the power amplifier.

The fuel compartment may also comprise other surfaces than the radiation output surface, being more or less impermeable for output electromagnetic radiation having a frequency of 500 GHz to 1.5 THz. This may e.g. be used to provide directional control of the output electromagnetic radiation.

The radiation input surface may be a first major surface of the fuel compartment. The radiation output surface may be a second major surface of the fuel compartment. The first and second major surfaces may be opposing each other. In a preferred design, the power amplifier is basically disc-shaped with two opposing major surfaces, with the radiation input surface being formed of one of the two opposing major surfaces of the disc and the radiation output surface being formed of the other one of the two opposing major surfaces of the disc.

The power amplifier may further comprise a microwave radiator configured to subject the fuel compartment to electromagnetic radiation having a frequency of 300 MHz to 300 GHz, preferably 2 to 3 GHz, more preferably 2.5 GHz.

In the following, the concept of gradient force in relation to the first and the second fuel components will be discussed. As will be elaborated on below, the gradient force may arise from the penetration of EM waves into matter in any aggregate state.

In plasma physics, the ponderomotive force is well-known to be an effective description of a time-averaged non-linear force which acts on a medium comprising charged particles in the presence of an inhomogeneous oscillating EM field. The basis of the time-averaged ponderomotive force is that EM waves transfer energy and momentum to matter.

Of the five potential ponderomotive effects, the Miller force and the Abraham force are considered to be the most powerful in a weakly magnetized, or magnetic gradient-free, environment. However, depending on the heating input electromagnetic radiation method effects of the magnetic gradient force cannot be excluded. Moreover, the Barlow force, induced by gas particle collisions may also influence the dynamics of the system.

The overall enabling ponderomotive acceleration force considered here is the Miller force or, equivalently, the gradient force.

Under the assumption that the fuel after being subjected to the input EM radiation may be treated as a plasma, the concept of gradient forcing may be applied. For two reasons, an Alfvén wave analogy will be chosen in deriving the gradient force in plasma. Firstly, because Alfvén waves have been observed in plasmas at all states, i.e. in plasma states, gaseous states, liquid states, and solid states. Secondly, because Alfvén waves have almost a frequency-independent response below resonance.

It is noted, however, that in general there may be a mixture of Alfvén waves and other waves, such as acoustic waves, in the plasma.

The plasma may be described as comprising ions and electrons, giving rise to a total neutral charge. Since the ion mass is typically more than 1800 times greater than the electron mass, the electron mass may be neglected. The mass density and the corresponding forcing upon the plasma is therefore determined by the ion mass, m. Alfvén waves having a frequency $\omega$ propagate along magnetic field lines $\boldsymbol{k}$ = (0,0, k) in Cartesian coordinates and have circular polarization. The following expression applies for the longitudinal gradient force (in cgs units) governed by Alfvén waves in a fluid:

$$F_z = -\frac{e^2}{4m(\omega^2 - \Omega^2)}\frac{\partial E^2}{\partial z} \,, \qquad (1)$$

where e is the elementary charge and where $\Omega$ is a cyclotron resonance frequency. The spatial gradient of the squared wave electric field $E^2$ in the z-direction determines the magnitude of the force. It is noted that the expression (1) has a singularity at $\omega^2 = \Omega^2$. Moreover, the gradient force is attractive for $\omega^2 < \Omega^2$ and repulsive for $\omega^2 > \Omega^2$. Thereby, low-frequency Alfvén waves having $\omega^2 < \Omega^2$ attract particles towards the wave source, while high-frequency Alfvén waves having $\omega^2 > \Omega^2$ repel the particles. Attraction at low frequencies may be conceived as intuitively wrong. However, it clearly applies for a plasma and has also been experimentally and theoretically confirmed for neutral solid-state matter. In addition to having this bipolar directional force shift at wave resonance, the gradient force is independent of the sign of the charge of the particle, due to the factor of $e^2$. This implies that the force for positive ions and electrons is directed in the same direction.

It is noted that neutral matter may be in a fluid state, a gas state, a plasma state, or a solid state. Since neutral matter on an atomic and nuclear level constitute charges, one may therefore consider atomic oscillations (e.g. Brownian motions) and interatomic vibrations as "fundamental frequencies". The electric field term of EM waves should therefore affect an atomic "media" bound by e.g. Van-der-Wahl forces in a similar way as a plasma bound by a strong magnetic field.

For unmagnetized neutrals the analogy implies that wave energy may penetrate, since the gradient force works on atomic protons, electrons and neutrons collectively.

For low-frequency waves such as $\omega^2 \ll \Omega^2$, the expression in equation (1) simplifies since $\omega$ may be ignored. In this case, the force becomes attractive, regardless of atomic structure or mass.

However, approaching resonance frequency $\omega^2 = \Omega^2$ the gradient force increases non-linearly. Resonance frequencies in plasma physics are related with the intrinsic fluid properties, such as a plasma density, a particle mass, a particle inertia, and the magnetic field.

Under the assumption that the EM waves irradiating the plasma are linearly polarized in many planes, the gradient force exerted on individual particles/atoms of mass $m_a$ by EM waves with a radiation electric field E becomes

$$F_z = -\frac{e^2}{4m_a(\omega^2 - \Omega_a{}^2)}\frac{\partial E^2}{\partial z} \quad . \qquad (2)$$

In particular, this expression may be valid for the first fuel component. The theoretical gradient force versus frequency in expression (2) resembles that of expression (1), except that we have now introduced a resonance frequency $\Omega_a$. The resonance frequency $\Omega_a$ may be a resonance frequency for matter in any aggregate state, i.e. solid, liquid, gas or plasma. The gradient force is again attractive over the entire frequency range below resonance, i.e. for $\omega^2 < (\Omega_a)^2$. Above resonance $\omega^2 > (\Omega_a)^2$, the force is repulsive. At frequencies well below resonance, $\omega^2 \ll (\Omega_a)^2$, the gradient force is independent of wave frequency and the following expression applies:

$$F_z \approx \frac{e^2}{4m_a\Omega_a{}^2}\frac{\partial E^2}{\partial z} \quad . \qquad (3)$$

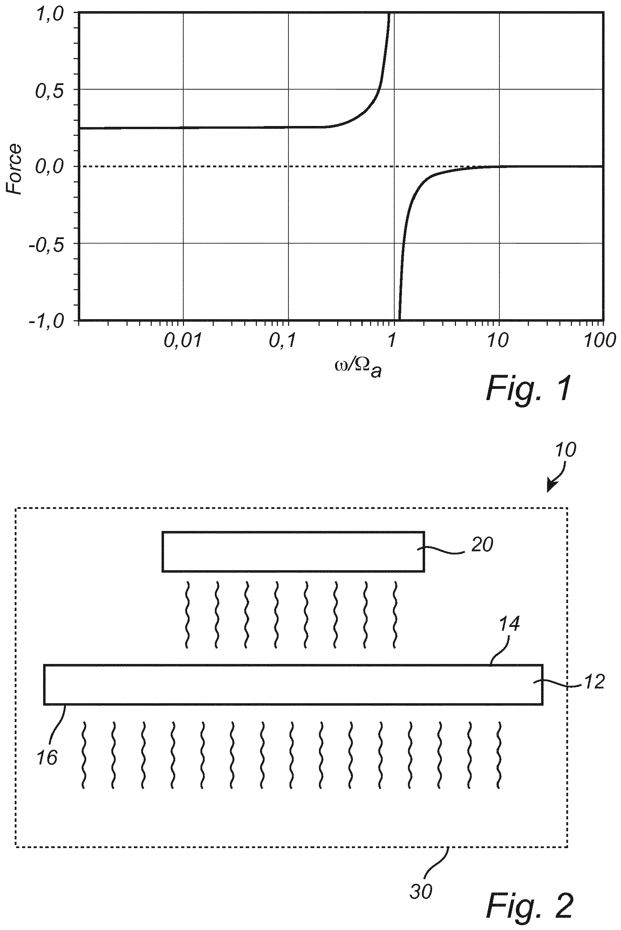

The attractiveness and repulsiveness of the gradient force is illustrated in Fig. 1, illustrating the gradient force as a function of $\omega/\Omega_a$. In Fig. 1 the Alfvén wave Gradient force versus normalized frequency for unit material constant ($e^2/4m_1$ $\frac{\partial E^2}{\partial z} = 0.25$ = 1), and of expression (2) is illustrated. The left hand curve marks attractive force and the right hand curve marks repulsive force.

If the matter is in a solid aggregate state, the resonance frequency may be written as $\Omega_a = c/a$, where a is the interatomic distance and c is the local speed of light in the media. In this case we get for $\omega^2 \ll (\Omega_a)^2$ the approximate expression

$$F_z \approx \frac{a^2 e^2}{4m_a c^2}\frac{\partial E^2}{\partial z} = \xi(a, m_a)\frac{\partial E^2}{\partial z} \quad . \qquad (4)$$

Here, the force depends on a material constant, $\xi(a, m_a)$, and the spatial gradient of the squared wave electric field $E^2$ propagating into the matter. The wave energy may go into heating and/or to kinetic energy and/or potential energy. Wave attraction is determined by the spatial gradient of $E^2$ which may be written as the quotient $\delta E^2/\delta z$, where $\delta E^2$ is a difference of $E^2$ over a differential interaction length $\delta z$. A material constant $\xi(a, m_a)$, the gradient $\delta E^2/\delta z$ and the transverse wave electric field E, now determines the gradient force exerted on individual atoms in the body. Notice that the interatomic distance a defines the binding force, or tension, in analogy with the magnetic field controlling the plasma motion. The a-factor may be a parameter defining resonance. There may be additional parameters for defining resonance.

More generally, u in the expression $\Omega_a = u/a$ is related with the local speed of EM waves in the media (e.g. acoustic, ion acoustic).

Analytical results derived from expression (4) has been demonstrated to be in good agreement with experimental findings from the Cavendish vacuum experiment.

For the first or the fuel components, the following expression for the gradient force may be obtained from equation (4) above:

$$F_z \approx K(a, m_a)\frac{\partial E^2}{\partial z} \quad . \qquad (5)$$

Here K(a, $m_a$) are characteristic properties of first and/or the second fuel compoents. The characteristic properties may be a corresponding atomic mass, a number of atoms, and an atomic separation distance, etc.

The gradient force may become stronger when the input power of the input EM radiation becomes stronger. For example, the gradient force in the low-frequency range $\omega^2 \ll (\Omega_a)^2$ is directly proportional to the input power of the input EM radiation.

As noted above, there may also arise Abraham forces in the plasma. The longitudinal Abraham force may in this case be described by $F_z = \pm(\frac{mc^2}{2c_A B^2}) \partial E^2 / \partial t,$ being proportional to the temporal variation of the squared electric field. $c_A$ is the Alfvén velocity and $B$ is the magnetic field. The plus or minus sign corresponds to wave propagation parallel or antiparallel with the direction of the magnetic field B, respectively. The Abraham force may be significant for fast changes of E and/or weak magnetic fields. The latter may be associated with low cyclotron resonance frequencies which may give low neutron production rates. The merit of the Abraham force may instead be to promote heating by the fast directional EM field changes.

The fact that EM waves in a plasma may lead to attraction is not obvious. Magnetohydrodynamic waves, MHD waves, are a class of waves in fluids where plasma and magnetic field display a mutual oscillation, the plasma considered "frozen" into the magnetic field. In a spatially unidirectional magnetic field the plasma resonance frequency, rather than the direction of wave propagation (+z-direction), determines the direction of the force. From $\Omega = eB/mc$ we have for low frequency waves, $\omega^2 \ll \Omega^2$ that $F_z \approx \frac{mc^2}{2B^2} \frac{\partial E^2}{\partial z}.$ This implies that the force is constant and independent of wave frequency in a homogeneous medium with constant B at low frequencies, the force being proportional to the gradient of the EM-wave intensity. Because the wave intensity is decreasing during interaction (exerting force on matter) the force is directed opposite to the wave propagation direction.

The concept of MHD waves stems from the fluid description of plasmas. MHD waves are governed by the magnetic tension in magnetized plasma. The stronger the magnetic tension, the weaker the wave group velocity and gradient force. In a similar way, MHD waves in solid-state plasma are governed by their dielectric properties and interatomic tension. While the local resonance frequency in gaseous magnetized plasma is determined by the ion gyrofrequency, the local resonance frequency in neutral solids and neutral gases, comprising atoms is less obvious. However, as already noted, the gradient force is charge-neutral, implying that the force on all particles goes in the same direction. Matter is subject to forcing by the local release of wave energy, characterized by a spatial gradient of the wave electric field. To establish transfer of neutrons from the first fuel component to the second fuel component in according to the inventive method, a certain mix of the first fuel component and the second fuel component is required. In the course of this nuclear process, and depending on the environment, other transfer of states, e.g. electron capture, may take place. However, with adequate system design these processes may have minor implications for the output energy budget.

Depending on a fuel temperature and wave resonance, the rate of neutron transfer in the fuel may achieve a state where an output power of the output electromagnetic radiation substantially exceeds an input power of the input electromagnetic radiation.

Besides heating the fuel, excess power from the nucleus mass increasing isotope shift may also enhance the rate of transfer of neutrons from the first fuel component to the second fuel component. The latter may be achieved by enhancing the input power of EM radiation to the fuel.

A further scope of applicability of the present invention will become apparent from the detailed description given below. However, it should be understood that the detailed description and specific examples, while indicating preferred embodiments of the invention, are given by way of illustration only, since various changes and modifications within the scope of the invention will become apparent to those skilled in the art from this detailed description.

Hence, it is to be understood that this invention is not limited to the particular component parts of the device described or steps of the methods described as such device and method may vary. It is also to be understood that the terminology used herein is for purpose of describing particular embodiments only, and is not intended to be limiting. It must be noted that, as used in the specification and the appended claim, the articles "a," "an," "the," and "said" are intended to mean that there are one or more of the elements unless the context clearly dictates otherwise. Thus, for example, reference to "a unit" or "the unit" may include several devices, and the like. Furthermore, the words "comprising", "including", "containing" and similar wordings does not exclude other elements or steps.

Brief Description of the Drawings

The above and other aspects of the present invention will now be described in more detail, with reference to appended drawings showing embodiments of the invention. The figures should not be considered limiting the invention to the specific embodiment; instead they are used for explaining and understanding the invention.

As illustrated in the figures, the sizes of layers and regions are exaggerated for illustrative purposes and, thus, are provided to illustrate the general structures of embodiments of the present invention. Like reference numerals refer to like elements throughout.

Fig. 1 illustrates a gradient force as a function of $\omega/\Omega_a$.

Fig. 2 illustrates a power amplifier including a microwave radiator.

Fig. 3 illustrates a power amplifier.

Fig. 4 is a block scheme of a method for amplifying power of electromagnetic radiation.

Detailed description

The present invention will now be described more fully hereinafter with reference to the accompanying drawings, in which currently preferred embodiments of the invention are shown. This invention may, however, be embodied in many different forms and should not be construed as limited to the embodiments set forth herein; rather, these embodiments are provided for thoroughness and completeness, and to fully convey the scope of the invention to the skilled person.

Fig. 2 illustrates a power amplifier 10 in accordance with the present invention. Especially, the power amplifier 10 is configured to amplify power of electromagnetic radiation. The power amplifier 10 comprises a fuel compartment 12. The fuel compartment 12 contains a mixture of a first fuel component and a second fuel component. The mixture of the first and second fuel components are gaseous before being subjected for input electromagnetic radiation.

The first fuel component is deuterium. Deuterium is chosen since it may undergo a nucleus mass reducing isotope shift upon being subjected to input electromagnetic radiation. By subjecting deuterium to input electromagnetic radiation, energy transfer may be provided by means of the wave-particle acceleration process as was more extensively discussed above in the summary of the invention section. The frequency range of the input electromagnetic radiation will be discussed in more detail below. Upon transferring energy to the deuterium it may assume a high-energy state wherein neutrons of the deuterium will be affected and a nucleus mass reducing isotope shift may occur. The mass reducing isotope shift in deuterium originate from the reaction channel $D + W_s \rightarrow n + {}^1H$, where D is deuterium, $^2H$, and where $^1H$ is protium, i.e. hydrogen with no neutron in the nucleus. Further, $W_s$ is the threshold energy for the mass reducing isotope shift to occur. The threshold energy for inducing a mass reducing isotope shift in D is 2.25 MeV. It is noted that $^1H$ as well as $^2H$, i.e. D, are stable isotopes per se. It is moreover noted that the reaction above may be induced by irradiation above the threshold energy.

In order to induce the mass reducing isotope shift in deuterium the fuel compartment 12 is configured to be subjected to input electromagnetic radiation. Further, by subjecting the mixture of the first and second fuel components to input electromagnetic radiation a plasma of the fuel mixture may be formed. The input electromagnetic radiation is advantageously chosen such that it is below the plasma resonance frequency of the first fuel component, hence the plasma resonance frequency of deuterium. In expressions (1) and (2) $\omega^2 = \Omega^2$ at the plasma resonance frequency. The plasma resonance frequency, $\omega_{ion}$, of an ion may be expressed as:

$$\omega_{ion} = 2\pi f_{ion} = \sqrt{\frac{n_0 e^2}{m_i \varepsilon_0}} \qquad (6)$$

wherein $n_0$ is the number of ions per volume, e is the electric charge, $m_i$ is the effective mass of the ion and $\varepsilon_0$ is the permittivity of free space. Hence, at normal air pressure the plasma resonance frequency of deuterium is $6.8 \cdot 10^{12}$ rad/s, hence 1.1 THz. By altering the pressure of the fuel mixture in the fuel compartment 12 the plasma resonance frequency of the deuterium may be altered. Thus, the input electromagnetic radiation may be chosen in the microwave range, 300 GHz to 300 MHz. By using a sufficient effect of input electromagnetic radiation the fuel mixture may be transformed into a plasma. Further, the sufficient effect of input electromagnetic radiation may induce the wave-particle acceleration process discussed above in the summary of the invention section such that the mass reducing isotope shift in deuterium may occur.

The power amplifier 10 may further comprise a microwave radiator 20. The microwave radiator 20 is configured to radiate microwaves in the range of 300 GHz to 300 MHz. Preferably, the microwave radiator 20 is configured to radiate microwaves in the range of 2 to 3 GHz. More preferably, the microwave radiator 20 is configured to radiate microwaves of 2.5 GHz. Using a microwave radiator 20 configured to radiate microwaves in the range of 2 to 3 GHz is advantageous since such microwave radiator 20 a readily available and relatively cheap since they today are used in microwave ovens. According to a non-limiting example the microwave radiator 20 may be a magnetron.

The power amplifier 10 may further be surrounded by a Faraday cage 30 for protecting the power amplifier 10 from radiating electromagnetic radiation to the surrounding environment. By surrounding the power amplifier 10 with the Faraday cage 30 overall efficiency of the power amplifier 10 may also be enhanced.

The second fuel component is another gas than deuterium. The second fuel component shall be chosen such that it may undergo a nucleus mass increasing isotope shift upon absorbing a neutron from the first fuel component upon the first fuel component undergoing the nucleus mass reducing isotope shift. Further, the second fuel component shall be chosen such that the available energy gained by the nucleus mass increasing isotope shift is greater than 2.25 MeV, the threshold energy for inducing the mass reducing isotope shift in D. Moreover, the resulting isotope of the nucleus mass increasing isotope shift in the second fuel component is preferably a stable isotope. According to a non-limiting example the second fuel component is nitrogen, preferably $^{14}$N. $^{14}$N is a good candidate for the second fuel component since after the nucleus mass increasing isotope shift $^{14}$N is transformed to $^{15}$N. Both $^{14}$N and $^{15}$N are stable isotopes of nitrogen. Further, $^{14}$N is a good candidate for the second fuel component since the mass increasing isotope shift from $^{14}$N to $^{15}$N will make available 10.8 MeV of energy. Hence, almost 5 times more energy than is need for the mass reducing isotope shift from D to H. The 10.8 MeV of energy will be released in the form of electromagnetic waves/photons, herein denoted as output electromagnetic radiation. The output electromagnetic radiation will be radiated as a pulse of electromagnetic radiation, the pulse comprising a plurality of photons. Each photon of the pulse of output electromagnetic radiation having a frequency close to the plasma resonance frequency of the second fuel component. Hence, for example, the at least 10.8 MeV of energy that will be released at each mass increasing isotope shift from $^{14}$N to $^{15}$N will be released as a pulse of electromagnetic radiation comprising a number of photons instead of a single photon having 10.8 MeV.

In the above mentioned example wherein the first fuel component is deuterium and the second fuel component is $^{14}$N, an initial ratio between the first and second fuel components is within 40/60 mol percentage to 60/40 mol percentage. Preferably, the initial ratio between the first and second fuel components is 50/50 mol percentage. Hence, for the case when the mass reducing isotope shift in the first fuel component is an isotope shift by one unit number and when the mass increasing isotope shift in the second fuel component is an isotope shift by one unit number a 50/50 mol percentage mixture is preferred. In this context the wording "initial ratio" shall be construed as a ratio between the first and second fuel components being initially present in the fuel compartment 12 in connection with manufacturing or installation of the power amplifier 10. Hence, the ratio between the first and second fuel components being present in the fuel compartment 12 before the power amplifier 10 has been used for amplifying energy of electromagnetic radiation. For other fuel mixtures other initial ratios between the first and second fuel components may be chosen. For example, if the first fuel component still is deuterium and if the second fuel component is a fuel component that may undergo a mass increasing isotope shift increasing the atomic mass by two units an initial ratio between the first and second fuel components may be 67 mol percentage of deuterium and 33 mol percentage of the second fuel component.

In the above mentioned example where the first fuel component is deuterium and the second fuel component is $^{14}$N and the initial ratio between deuterium and $^{14}$N is 50/50 mol percentage, theoretically a fuel compartment 12 comprising 0.35 liters of $D_2$ $^{14}N_2$ comprises 2000 kWh of energy.

The fuel compartment 12 is preferably gas tight for the first and second gaseous fuel components. The fuel compartment 12 may be a closed compartment. The fuel compartment 12 may be a pressure chamber. By means of the pressure chamber a pressure of the fuel mixture in the fuel compartment 12 may be adjusted and controlled. The pressure of the fuel mixture may be varied in order to adjust the plasma resonance frequency of the first fuel component, i.e. the deuterium.

The fuel compartment 12 comprises a radiation input surface 14 permeable for the input electromagnetic radiation having a frequency of 300 MHz to 300 GHz, preferably 2 to 3 GHz, more preferably 2.5 GHz. Further, the fuel compartment 12 comprises a radiation output surface 16 permeable for the output electromagnetic radiation. Hence, the input electromagnetic radiation may be directed towards the radiation input surface 14 and the output electromagnetic radiation may escape from the radiation output surface 16.

According to a non-limiting example, the fuel compartment 12 may be disc shaped. According to another non-limiting example, the fuel compartment 12 may be a cuboid. According to yet another non-limiting example, the fuel compartment 12 may be a tubular. In case the fuel compartment 12 is disc shaped or a cuboid, the radiation input surface 14 of the fuel compartment 12 is a first major surface of the fuel compartment 12. Further, in case the fuel compartment 12 is disc shaped or a cuboid, the radiation output surface 16 is a second major surface of the fuel compartment 12. The first and second major surfaces are preferably opposing each other. Together, the first and second major surfaces preferably constitutes 80-90% of the total surface area of the fuel compartment 12.

Hence, the present invention is directed towards the insight made by the inventor that energy of microwaves, e.g. emitted from an ordinary magnetron used in today's microwave ovens, may be amplified by directing such microwaves towards a fuel mixture comprising deuterium and another gaseous component. The deuterium of the fuel mixture undergoes a mass reducing isotope shift induced by the energy of the microwaves. As a result, there will be neutrons available for a second fuel component in the fuel mixture to undergo a mass increasing isotope shift. By proper selection of the second fuel component the energy gained by the mass increasing isotope shift is higher than the energy needed to induce the mass reducing isotope shift in the deuterium. The fuel mixture is preferably a gaseous fuel mixture, at least before being subjected for the input electromagnetic radiation. Preferably, the fuel mixture is comprised in a closed fuel compartment. The frequency of the input electromagnetic radiation directed towards the fuel mixture may be chosen based on the pressure of the fuel mixture.

A fuel compartment comprising the fuel mixture is easy to recycle since the rest products after usage is hydrogen and another gas, in the above mentioned example $^{15}N$.

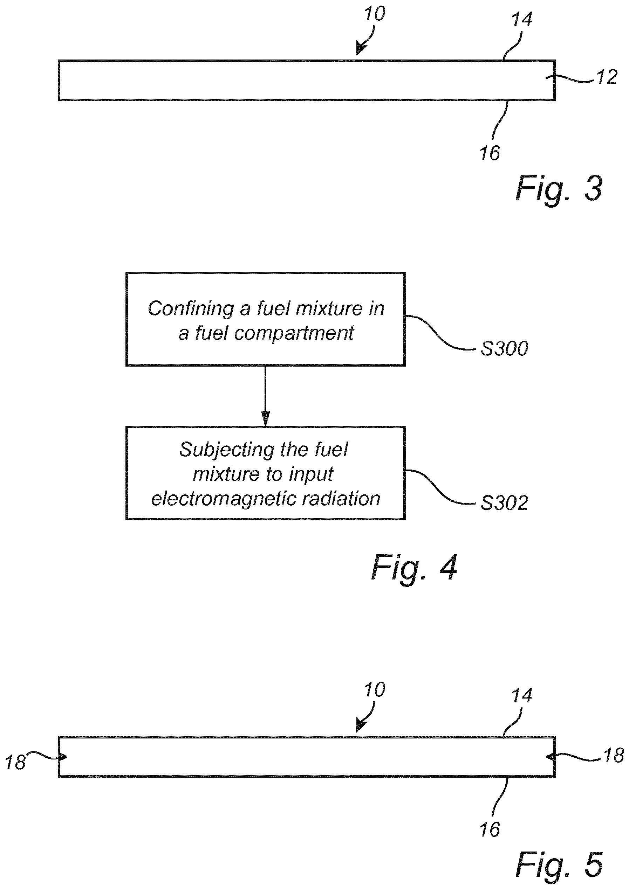

It may, with reference to fig. 3 also be noted that the power amplifier 10 may be delivered as a separate entity basically formed of a fuel compartment 12. Such power amplifier 10 may be fitted into a device comprising a microwave radiator. Such a power amplifier 10 may be used for replacement of other power amplifiers which has reached their end of life or as retrofitting into different kinds of devices having microwave radiators.

With reference to Fig. 4, a method for amplifying power of electromagnetic radiation will now be discussed. The method comprising the following act. It is realized that the acts do not necessarily need to be performed in the order listed below. Confining S300 a fuel mixture in a fuel compartment 12. The fuel mixture comprising a first and a second fuel component. The first fuel component is deuterium in gas phase. The second fuel component is another gas than deuterium. The act of confining S300 the fuel mixture in the fuel compartment 12 may comprise selecting the second fuel component such that a nucleus mass reducing isotope shift in deuterium is less energy requiring than a nucleus mass increasing isotope shift in the second fuel component. Subjecting S302 the fuel mixture to input electromagnetic radiation such that a nucleus mass reducing isotope shift in the deuterium, a nucleus mass increasing isotope shift in the second fuel component, and output electromagnetic radiation resulting from the nucleus mass increasing isotope shift is produced. As a result, power of the output electromagnetic radiation may be amplified as compared with the power of the input electromagnetic radiation.

The second fuel component may be nitrogen, preferably $^{14}N$.

The act of confining S300 the fuel mixture in the fuel compartment 12 may comprise confining 40-60 mol percentage of deuterium in the fuel compartment 12 and confining 60-40 mol percentage of the second fuel component in the fuel compartment 12. Preferably, especially in case of the second fuel component being $^{14}N$, the act of confining S300 the fuel mixture in the fuel compartment 12 comprise confining 50 mol percentage of deuterium in the fuel compartment 12 and confining 50 mol percentage of the second fuel component in the fuel compartment 12.

The act of subjecting S302 the fuel mixture to input electromagnetic radiation may comprise subjecting the fuel mixture to input electromagnetic radiation having a frequency of 300 GHz to 300 MHz. Hence, subjecting the fuel mixture to microwave input electromagnetic radiation.

The act of subjecting S302 the fuel mixture to input electromagnetic radiation may comprise subjecting the fuel mixture to input electromagnetic radiation having a frequency of 2 to 3 GHz, preferably 2.5 GHz. Hence, subjecting the fuel mixture to microwave input electromagnetic radiation readily available from microwave radiators available for today's microwave ovens.

The person skilled in the art realizes that the present invention by no means is limited to the preferred embodiments described above. On the contrary, many modifications and variations are possible within the scope of the appended claims.

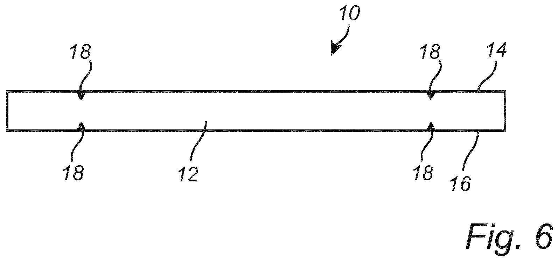

For example, the power amplifier 10 may comprise two or more spark inducing pins 18. This is illustrated in Figs 5 and 6. The pins 18 are preferable made of a metal, such as tungsten. By subjecting the pins for the input electromagnetic radiation a spark between the pins 18 may be generated. The pins 18 may also be connected to a power source in order to apply a potential difference between the pins for generating a spark between the pins 18. The generated spark may be used to induce a plasma in the fuel mixture.

Additionally, variations to the disclosed embodiments can be understood and effected by the skilled person in practicing the claimed invention, from a study of the drawings, the disclosure, and the appended claims.

**Claims**

1. A method for amplifying power of electromagnetic radiation, the method comprising:

    subjecting a fuel mixture to input electromagnetic radiation, the fuel mixture comprising a first and a second fuel component, the first fuel component being gaseous deuterium and the second component being another gas than deuterium, for producing:

        a nucleus mass reducing isotope shift in the deuterium,
        a nucleus mass increasing isotope shift in the second fuel component, and
        output electromagnetic radiation resulting from the nucleus mass increasing isotope shift;

wherein the nucleus mass reducing isotope shift in deuterium is less energy requiring than the nucleus mass increasing isotope shift in the second fuel component.

2. The method according to claim 1, wherein the second fuel component is nitrogen, preferably [14]N.

3. The method according to claim 1 or 2, wherein an initial ratio between the first and second fuel components is within 40/60 mol percentage to 60/40 mol percentage, preferably 50/50 mol percentage.

4. The method according to any one of claims 1-4, wherein the input electromagnetic radiation has a frequency of 300 GHz to 300 MHz.

5. The method according to any one of claims 1-5, wherein the input electromagnetic radiation has a frequency of 2 to 3 GHz, preferably 2.5 GHz.

6. The method according to any one of claims 1-4, wherein the output electromagnetic radiation has a frequency of 500 GHz to 1.5 THz.

7. A power amplifier for amplifying power of electromagnetic radiation, the power amplifier comprising:

    a first gaseous fuel component being deuterium;
    a second gaseous fuel component, the second component being another gas than deuterium, the second gaseous fuel component being selected such that a nucleus mass reducing isotope shift in deuterium is less energy requiring than a nucleus mass increasing isotope shift in the second fuel component; and
    a fuel compartment (12) containing a mixture of the first and second gaseous fuel components.

8. The power amplifier according to claim 7, wherein the second fuel component is nitrogen, preferably [14]N.

9. The power amplifier according to claim 7 or 8, wherein an initial ratio between the first and second fuel components is within 40/60 mol percentage to 60/40 mol percentage, preferably 50/50 mol percentage.

10. The power amplifier according to any one of claims 7-9, wherein the fuel compartment (12) is gas tight for the first and second gaseous fuel components.

11. The power amplifier according to any one of claims 7-10, wherein the fuel compartment (12) is a closed compartment.

12. The power amplifier according to any one of claims 7-11, wherein the fuel compartment (12) comprises a radiation input surface (14) permeable for input electromagnetic radiation having a frequency of 300 MHz to 300 GHz, preferably 2 to 3 GHz, more preferably 2.5 GHz.

13. The power amplifier according to any one of claims 7-12, wherein the fuel compartment (12) comprises a radiation output surface (16) permeable for output electromagnetic radiation having a frequency of 500 GHz to 1.5 THz.

14. The power amplifier according to claims 12 and 13, wherein the radiation input surface (14) is a first major surface of the fuel compartment (12) and wherein the radiation output surface (16) is a second major surface of the fuel compartment, wherein the first and second major surfaces are preferably opposing each other.

15. The power amplifier according to any one of claims 7-14, wherein the power amplifier further comprises a microwave radiator (20) configured to subject the fuel compartment (12) to electromagnetic radiation having a frequency of 300 MHz to 300 GHz, preferably 2 to 3 GHz, more preferably 2.5 GHz.

*Fig. 1*

*Fig. 2*

*10* *14*

*12*

*16*

# Fig. 3

Confining a fuel mixture in a fuel compartment — S300

Subjecting the fuel mixture to input electromagnetic radiation — S302

# Fig. 4

*10* *14*

*18* *18*

*16*

# Fig. 5

Fig. 6

Europäisches
Patentamt

European
Patent Office

Office européen
des brevets

# EUROPEAN SEARCH REPORT

**Application Number**

EP 17 17 0750

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X,D | EP 3 086 323 A1 (LIDGREN HANS [MC]; LUNDIN RICKARD [SE]) 26 October 2016 (2016-10-26) | 1,3,7, 9-11,13, 14 | INV. G21B3/00 H05H1/46 |
| Y | * paragraph [0007] * <br> * paragraph [0080] * <br> * paragraph [0103] - paragraph [0126] * <br> * paragraph [0143] * <br> * figure 2 * | 2,4,5,8, 12,15 | |
| Y | WO 02/29826 A1 (CHENG SING WANG [US]; CHENG HSIANG WEI [US]) 11 April 2002 (2002-04-11) <br> * page 9, last paragraph * <br> * figure 3 * | 2,8 | |
| Y | US 2011/000780 A1 (TIAN CAIZHONG [JP] ET AL) 6 January 2011 (2011-01-06) <br> * paragraph [0051] - paragraph [0052] * <br> * figure 1 * | 4,5,12, 15 | |
| | | | TECHNICAL FIELDS SEARCHED (IPC) <br><br> G21B <br> H05H <br> H01J |

The present search report has been drawn up for all claims

| Place of search | Date of completion of the search | Examiner |
|---|---|---|
| The Hague | 27 September 2017 | Capostagno, Eros |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 17 17 0750

This annex lists the patent family members relating to the patent documents cited in the above-mentioned European search report.
The members are as contained in the European Patent Office EDP file on
The European Patent Office is in no way liable for these particulars which are merely given for the purpose of information.

27-09-2017

| Patent document cited in search report | | | Publication date | Patent family member(s) | | | Publication date |
|---|---|---|---|---|---|---|---|
| EP | 3086323 | A1 | 26-10-2016 | EP | 3086323 | A1 | 26-10-2016 |
| | | | | WO | 2016169741 | A1 | 27-10-2016 |
| WO | 0229826 | A1 | 11-04-2002 | AU | 7856900 | A | 15-04-2002 |
| | | | | TW | 517247 | B | 11-01-2003 |
| | | | | WO | 0229826 | A1 | 11-04-2002 |
| US | 2011000780 | A1 | 06-01-2011 | CN | 101953236 | A | 19-01-2011 |
| | | | | JP | 5243457 | B2 | 24-07-2013 |
| | | | | JP | WO2009101927 | A1 | 09-06-2011 |
| | | | | KR | 20100101014 | A | 15-09-2010 |
| | | | | TW | 200944071 | A | 16-10-2009 |
| | | | | US | 2011000780 | A1 | 06-01-2011 |
| | | | | WO | 2009101927 | A1 | 20-08-2009 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 3086323 A1